# EUROPÄISCHE PATENTSCHRIFT

(11) **EP 4 476 771 B1**
(45) Veröffentlichungstag und Bekanntmachung des Hinweises auf die Patenterteilung: **04.11.2026**
(21) Anmeldenummer: 22729441.0
(22) Anmeldetag: 28.04.2022
(51) Int. Cl.: H10F 19/80

(54) **VERFAHREN ZUR TRENNUNG VON WERTSTOFFEN IN EINEM VERBUNDBAUTEIL**
METHOD FOR SEPARATING REUSABLE MATERIALS IN A COMPOSITE COMPONENT
PROCÉDÉ POUR SÉPARER DES MATÉRIAUX VALORISABLES D`UN ÉLÉMENT COMPOSITE

(30) Priorität: 07.02.2022 DE 102022102778; 14.04.2022 DE 102022109347
(43) Veröffentlichungstag der Anmeldung: 18.12.2024
(73) Patentinhaber: Flaxtec GmbH, 01307 Dresden (DE)
(72) Erfinder: GROSS, Harald, 01465 Langebrück (DE)
(74) Vertreter: Lippert Stachow Patentanwälte Rechtsanwälte Partnerschaft mbB
(86) Internationale Anmeldenummer: PCT/DE2022/200078
(87) Internationale Veröffentlichungsnummer: WO 2023/147803

(56) Entgegenhaltungen:
- EP-A2- 2 133 923
- DE-A1- 102013 100 335
- US-A1- 2019 308 405
- US-A1- 2020 198 316

## Beschreibung

Die Erfindung betrifft allgemein ein Verfahren zur Trennung von Wertstoffen in einem Verbundbauteil, welches mindestens eine die Energie einer elektromagnetischen Strahlungsquelle absorbierende Materialschicht und zumindest eine Kunststofffolie umfasst. Alternativ kann die Kunststofffolie unmittelbar oder mittelbar unter Zwischenlage einer wärmeleitenden Schicht an die absorbierende Materialschicht angrenzen und so eine die Energie der elektromagnetischen Strahlungsquelle, nachfolgend verkürzt als Strahlungsquelle bezeichnet, absorbierende Schichtenfolge bilden. In einem gattungsgemäßen Trennverfahren wird die absorbierende Materialschicht oder Schichtenfolge mithilfe der Strahlungsquelle in einem Belichtungsfeld in weniger als einer Sekunde erwärmt. Die Erfindung betrifft insbesondere Verfahren zur Wertstofftrennung in Solarenergiemodulen, wie Photovoltaik-Modulen oder wie Komponenten von "Concentrated Solar Power"-Modulen, oder aus dem Bereich der Displays.

Photovoltaik-Module und Displays fallen nach ihrer bestimmungsgemäßen Nutzung unter die Kategorie "Elektronikschrott" und enthalten wertvolle, wiederverwendbare Rohstoffe. In der Europäischen Union muss Elektronikschrott nach EU-Richtlinien recycelt werden. Die Module enthalten je nach Bauart beispielsweise Silizium-Wafer und Silber oder seltene Stoffe wie Indium, Gallium oder Tellur sowie weitere Materialien in einem Verbund.

Ein Verbundbauteil besteht aus mehreren Komponenten, die bei dessen Verwendung zur Realisierung seiner Funktion zusammenwirken und zu diesem Zweck über die Dauer der Verwendung des Verbundbauteils miteinander verbunden bleiben sollen. Temporäre Verbindungen einzelner Komponenten untereinander oder mit Hilfsmitteln im Verlauf der Herstellung von Verbundbauteilen vor deren Fertigstellung sollen nicht unter den hier verwendeten Begriff des Verbundbauteils fallen.

Das Belichtungsfeld der Strahlungsquelle umfasst regelmäßig zumindest einen Anteil der Oberfläche des Verbundbauteils, so dass die absorbierende Materialschicht und gegebenenfalls mit dieser die absorbierende Schichtenfolge abschnittsweise oder optional vollständig erwärmt wird.

Ein besonderer Fall zur Trennung von Verbundbauteilen wird in der Patentanmeldung WO 2018/137735 A1 beschrieben. Die hierbei für die Trennung bevorzugte Strahlungsquelle ist eine oder mehrere Gasentladungslampen zur Erwärmung eines Wertstoffs in Photovoltaik-Modulen. Gegenwärtig ist das bevorzugte, wiederverwertbare Material Silizium. Das Verfahren kann jedoch auch auf andere Materialien und andere Verbundbauteilen angewendet werden. Auf das Verfahren der WO 2018/137735 A1 wird inhaltlich vollumfänglich Bezug genommen.

Etwa 85% aller hergestellten Photovoltaik-Module bestehen im Wesentlichen aus einem Verbund aufeinanderfolgender Materialien in Form eines Schichtstapels: Glasscheibe / obere Kunststofffolie / mehrere, in einer Ebene parallel zur Glasscheibe nebeneinander liegende Silizium-Wafer / Folienverbund. Letzterer besteht aus mehreren Kunststofffolien. An diesem Beispiel soll das erfindungsgemäße Verfahren später erläutert werden.

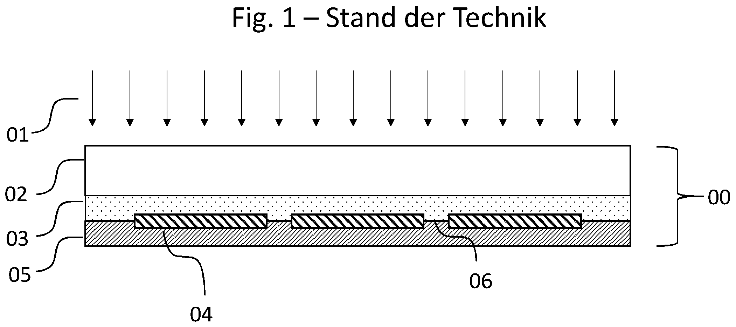

Bei der WO 2018/137735 A1 fällt intensives sichtbares Licht 01 weniger als eine Sekunde lang durch die Glasscheibe 02 der Frontseite eines Photovoltaik-Moduls 00, beispielsweise dargestellt in Fig. 1, durch die daran angrenzende obere, für sichtbares Licht transparente Kunststofffolie 03 und wird von der darunterliegenden, das Licht der Strahlungsquelle absorbierenden Materialschicht, das sind beispielsweise in erster Näherung quadratische, nebeneinander in einer Ebene liegende Silizium-Wafer 04, absorbiert. Aufgrund der Lichtabsorption erwärmt sich die Materialschicht, sodass sich die mit ihnen verbundenen Kunststofffolien 03, 05 ablösen. Dabei entstehen Pyrolysegase in wenige Mikrometer dicken Schichten der Kunststoffe, die direkt an die absorbierende Materialschicht angrenzen.

Die mit den Silizium-Wafern direkt verbundene Kunststofffolie des Folienverbunds 05 besteht typischerweise aus dem gleichen Material wie die obere Kunststofffolie 03. Der Folienverbund, der darüber hinaus weitere Folien umfasst, wird in der Fachliteratur als Rückseitenfolie bezeichnet. Im Folgenden soll zur Vereinfachung der Folienstapel 05 auf der Unterseite des Wafers als untere Kunststofffolie 05 und die Folie auf der Oberseite des Wafers als obere Kunststofffolie 03 bezeichnet werden.

Zwischen den Silizium-Wafern gibt es Bereiche 06 von Kunststoffen, im Folgenden "Stege" genannt, die während der Produktion der Photovoltaik-Module bei der Lamination der oberen und unteren Kunststofffolien 03, 05 auf die Ober- bzw. Unterseite der Wafer entstehen. Die Stege 06 verhindern in dem oben beschriebenen Verfahren der WO 2018/137735 A1 eine vollständige Trennung der Folien 03 von 05 mittels Belichtung. Somit verbleibt das Silizium nach der Belichtung typischerweise in Folientaschen, welche an den Stegen miteinander verbunden sind. Die untere Kunststofffolie bleibt nach der Belichtung über die Stege an der oberen Kunststofffolie haften.

Da mehrere Parameter der Verbundbauteile, wie die Kunststoffsorten, die Abmessungen der Wafer, deren Lichtabsorptionsgrade und Abstände untereinander, d. h. deren Stegbreiten, und viele andere nicht nur zwischen verschiedenen Herstellern der Module, sondern auch zwischen Modulgenerationen eines Herstellers stark schwanken, ist es im praktischen Anwendungsfall nahezu unmöglich eine optimale und gleichzeitig für alle Modulsorten einheitliche Lichtdosis zur Trennung der Materialschichten einzustellen. Um eine vollständige und sichere Trennung der zu separierenden Materialien, beispielsweise des Halbleiters als absorbierende Materialschicht, z. B. des Siliziums, von den Kunststoffen des Verbundbauteils in möglichst allen Fällen zu gewährleisten, muss deshalb eine Mindesttemperatur und damit korrelierte Mindestlichtdosis gewählt werden.

Die Mindestlichtdosis führt bei den meisten Photovoltaik-Modulen zu einer umfangreicheren als gewünschten Pyrolyse der Kunststoffe und folglich zu einer übermäßigen Gasproduktion sowie zu schwärzlichen Niederschlägen auf dem Silizium und den daran angrenzenden Kunststoffoberflächen. In der Praxis erfolgt die Trennung der Materialschicht nicht gleichmäßig, nicht wiederholbar und nicht an derselben Stelle, selbst bei Modulen des gleichen Typs und bei gleichen Prozessparametern. In Extremfällen durchdringen einzelne Siliziumbruchstücke den Folienstapel 05 oder bleiben in diesem stecken aufgrund von Temperaturen weit über der Mindesttemperatur und als Folge übermäßiger Gasproduktion.

Ist das im allgemeinen getemperte obere Deckglas bereits vor der Belichtung gebrochen, so kann sich die Glasscheibe, deren Splitter noch durch die obere Kunststofffolie 03 miteinander verbundenen sind, in Richtung Lichtquelle wölben. Dabei kann Pyrolysegas austreten, es können sich Splitter ablösen und letztendlich kann auch die Lichtquelle beeinträchtigt oder sogar beschädigt werden. Manche der Kunststoffe des Folienstapels 05 haben aufgrund deren Alterungsgrades im UV-Licht der Sonne nur noch eine geringe mechanische Belastbarkeit, sodass sich der Folienstapel 05 in viele kleine Stücke auflöst, die sich mit dem Silizium vermischen und folglich eine aufwendige nachträgliche Sortierung wie beispielsweise durch einen Windsichter erforderlich machen.

Es besteht somit die Aufgabe, die als Wertstoff wiederverwendbaren Materialien des Verbundbauteils, beispielsweise der Halbleiter der Wafer, insbesondere das Silizium oder andere, als die elektronischen Komponenten aus dem noch bestehenden Verbund mit einer Glasscheibe und/oder einer der Kunststofffolien zu separieren, um sie im Anschluss extrahieren zu können.

Des Weiteren soll die Mindestlichtdosis optimiert, insbesondere im Vergleich zu den bekannten Verfahren vermindert werden. Damit wird es u.a. möglich, die zuvor beschriebenen negativen Auswirkungen und Schäden am Verbundbauteil oder an der Vorrichtung zu vermeiden.

Des Weiteren soll die Trennung der Materialien des Verbundbauteils und in Folge die Extraktion von dessen Wertstoffen im industriellen Maßstab realisierbar sein und dabei für Verbundbauteile unterschiedlicher Generationen und Hersteller mit gleichbleibender oder automatisierbar geregelter Lichtdosis anwendbar sein.

Erfindungsgemäß erfolgt die Trennung des Wertstoffs unter Nutzung der thermochemischen Zersetzung der Grenzlage der Kunststofffolie unter Abwesenheit von Sauerstoff in der Grenzlage. Die dafür benötigte Energie steht, wie oben zum Stand der Technik beschrieben, infolge der Absorption der in weniger als einer Sekunde einfallenden Strahlung durch die absorbierende Materialschicht des Verbundbauteils zur Verfügung. Erfindungsgemäß wird hierzu vor der Erwärmung zumindest eine Sollbruchstelle derart in die zumindest eine Kunststofffolie eingebracht, dass an der Sollbruchstelle die Kunststofffolie unter dem Druck des infolge der pyrolytischen Spaltung chemischer Verbindungen des Kunststoffs entstehenden Pyrolysegases bricht.

Die Dauer der Belichtung hängt insbesondere von den involvierten Materialien und deren Schichtenfolge im Verbundbauteil ab. Sie ist augenscheinlich derart zu definieren, dass die eingebrachte Strahlungsenergie ausreichend ist, um die thermische Zersetzung zu bewirken und die Entstehung einer solchen Menge von Gas zu gewährleisten, dass die Kunststofffolie infolge der Gasentwicklung im Belichtungsfeld von der benachbarten Schicht gelöst wird.

Die Belichtungsdauer einer Belichtung zur Trennung der Schichten kann wesentlich kleiner sein als eine Sekunde. Sie hängt von vielen Parametern ab, welche mit der Absorption und Wärmeübertragung innerhalb des Verbundbauteils zusammenhängt. Bei verschiedenen Typen von Photovoltaikmodulen kann mit Belichtungszeiten beispielsweise im Bereich von 5 µs bis 500 ms, alternativ von 100 µs bis 100 ms, weiter alternativ von 500 µs bis 50 ms die Trennung der absorbierenden Materialschicht erfolgen. Auch mit Belichtungszeiten unterhalb einer Millisekunde kann das Verfahren ausgeführt und die Wertstoffe separiert werden. In Abhängigkeit von verschiedenen Parametern können alle Zwischenwerte verwendbar sein.

Die Belichtungszeit hängt beispielsweise von dem Material und der Schichtdicke der absorbierenden Materialschicht (in Mikrometern) ab, ebenso vom Material und der Schichtdicke der angrenzenden Materialschichten, da diese die Wärmeverluste durch Wärmeübertragung bestimmen und weiterhin von Art und Betrieb der Strahlungsquelle. Ein weiterer Parameter ist die für die thermische Zersetzung des Kunststoffs zu erzielende Temperatur. Ein wesentliches Maß für die Belichtungsdauer sind Material und Schichtdicke der absorbierenden Materialschicht, weshalb beispielsweise Dünnschicht-Solarmodule, deren lichtabsorbierende Schicht um ungefähr zwei Größenordnungen dünner ist, deutlich abweichende Zeiten benötigen können.

In der nachfolgenden Tabelle werden einige der genannten Parameter für verschiedene absorbierende Materialien beispielhaft, jedoch nicht beschränkend angeführt.

Alle Werte sind nur ungefähre Werte. Die Wärmekapazität spielt eine untergeordnete Rolle und ist daher hier nicht berücksichtigt. Bei höheren Temperaturen spielt Wärmestrahlung eine deutliche Rolle, da sie proportional zur vierten Potenz der Temperatur ist.

Ebenso ist die Lichtabsorption ein wichtiger Faktor, beispielsweise absorbieren Silber und Aluminium hauptsächlich im UV-Bereich, weshalb in diesem Fall kürzere Pulsdauern erforderlich sind für höhere Stromdichten in den Blitzlampen bzw. eine stärkere UV-Emission.

Das Beispiel der Fensterscheibe ist nur zum Vergleich eingetragen, enthält aber kein Polymer.

Glas Frit besteht nach dem Tempern oftmals und überwiegend aus Glas und Bleioxid. Aufgrund der schlechten Wärmeleitfähigkeit des Glas Frit muss die Belichtungsdauer sehr lang sein bei geringer Intensität.

| **Absorbierende Materialschicht** | **Einbettungs-material** | **erforderliche Temperatur [C]** | **Belichtungsdauer [ms]** | **Materialdicke [um]** |
|---|---|---|---|---|
| Silizium-Wafer (PV) | Polymer/Polymer | ca. 500-800 | 3-30 | 180-400 |
| Silber | Glas/Luft | ca. 400 | 0.05 | 0.01 |
| Dünnschicht Photovoltaik | Glas/Polymer | ca. 400 | 0.5 | 2 |
| Aluminium | Polymer/Hartpappe | ca. 500 | 0.1 | 0.03 |
| Glas Frit | Keramik/Glas | ca. 350 | 200 | 40 |

Die obige Tabelle zeigt nur einige wenige Parameter zur Festlegung der Belichtungsdauer. Für den jeweils aktuellen Fall ist diese anhand der Gegebenheiten durch Versuche und/oder Simulation zu ermitteln.

Als Belichtungsfeld wird im Sinne der Erfindung jener flächige Abschnitt eines Verbundbauteils verstanden, in welchem das Licht der externen Strahlungsquelle einfällt. Das schließt auch ein Belichtungsfeld in der Größe des Verbundbauteils oder größer ein.

Der Begriff der externen Strahlungsquelle bezeichnet hier eine solche Quelle, die nicht Bestandteil des Verbundbauteils, jedoch Bestandteil einer Vorrichtung zur Ausführung des Verfahrens ist.

Als Lichtdosis wird allgemein die während eines Belichtungsvorganges einer definierten Dauer in das Verbundbauteil innerhalb des Belichtungsfeldes eingebrachte Strahlungsenergie verstanden, bezogen auf die behandelte Masse. Letztere wird bestimmt durch die Größe des Verbundbauteils innerhalb eines Belichtungsfeldes.

Anhand der Materialien der involvierten Schichten der in einem Verfahrenszyklus zu behandelnden Verbundbauteile und unter Verwendung geeigneter Simulationen und/oder Versuche ist die für einen Zyklus bevorzugte Mindestlichtdosis ermittelbar.

Infolge der beschriebenen pyrolytischen Zersetzung einer dünnen Grenzlage der Kunststofffolie zur benachbarten, heißen Materialschicht entstehen gasgefüllten Taschen über dem strahlungsabsorbierenden Material. Die oben zum Stand der Technik beschriebene, auch nach der Belichtung verbleibende Verbindung zwischen beiden Kunststoffschichten, resultiert aus der mangelnden Absorption und somit mangelnder Erwärmung der Stege oder anderer, nicht oder wenig absorbierenden Bestandteile des Verbundbauteils und begrenzt die Taschen.

Die Öffnung der mit Gas gefüllten Taschen wird mittels einer oder mehrerer Sollbruchstellen in der unteren Kunststofffolie initiiert und optimal für alle Sollbruchstellen realisiert. Im Ergebnis liegt die angrenzende heiße Materialschicht zumindest abschnittsweise frei. Die zumindest eine Sollbruchstelle, bevorzugt die mehreren Sollbruchstellen, werden vor der Belichtung der Verbundbauteile in der Kunststofffolie erzeugt.

Die Sollbruchstellen gestatten eine gezielte und für die verschiedensten Modultypen reproduzierbare Öffnung der Kunststofffolie. Aufgrund der Bedingung der Mindestlichtdosis für die Behandlung verschiedener Ausführungen eines Typs von Verbundbauteilen kann übermäßig generiertes Gas entweichen, ohne negative Folgen am Verbundbauteil oder an der Vorrichtung zu verursachen. Denn im Übermaß generierte Gase können keinen derart hohen Druck zwischen absorbierender Materialschicht und Kunststofffolie aufbauen, sodass es nicht zu einer Wölbung des Deckglases oder Beeinträchtigung der Lichtquelle bei gebrochenem Glas kommt. Bruchstücke der heißen Materialschicht werden aus den Öffnungen herausgeschleudert anstelle die Kunststofffolien zu durchdringen oder in diesen stecken zu bleiben, wie es ohne Sollbruchstellen geschehen würde.

Als Sollbruchstelle soll hier eine lokale durch eine besondere Struktur und/oder Gestalt bestimmte Stelle der unteren Kunststofffolie verstanden sein, die von der Unterseite in die Kunststofffolie eingebracht ist und bei einer Belastung infolge der Ausbildung mit Gas gefüllter Taschen definiert bricht. Die Sollbruchstelle kann die Kunststofffolie teilweise oder vollständig durchdringen.

Die geometrische Gestalt der Sollbruchstelle kann beliebig sein, Beispielsweise können Ritzspuren oder Schnitte in die Kunststofffolien eingebracht werden, wobei erfindungsgemäß in einem ersten Schritt Sollbruchstellen in das Verbundbauteil geschnitten werden und in einem zweiten Schritt der im Verbundbauteil eingebettete Wertstoff durch eine Strahlungsquelle von außen erwärmt wird. Durch die Erwärmung erfolgt eine Trennung der Verbundmaterialien und es entstehen dabei Gase. Die Gase unterstützen den Trennungsvorgang und können durch die Sollbruchstellen gezielt aus dem Verbundbauteil heraustreten. Sie können noch während der Belichtung zur Extraktion des Wertstoffs beitragen, so dass eine geringere Lichtdosis für die Trennung des Siliziums von den Kunststoffen erforderlich ist.

Alternativ können die Sollbruchstellen flächenhaft ausgebildet sein, wie Bohrungen oder ähnliches. Flächenhafte Einschnitte können gleichmäßig verteilt oder an einer oder mehreren Stellen konzentriert werden, beispielsweise pro Waferfläche. Es gibt auch die Möglichkeit die Kunststofffolie nicht nur am Rand des Wafers, also mit quadratischer Form oder U-förmig aufzuschneiden, sondern beispielsweise auch in mehrere, kleinere mäanderförmige Streifen, welche auf einer Seite mit den Stegen verbunden bleiben. Dies ermöglicht eine weitere Reduzierung des Gasdrucks bei der Pyrolyse. Die lokale Verteilung der Sollbruchstellen eines Verbundbauteils ist so vorzunehmen, dass jede zu erwartende Tasche zumindest eine Sollbruchstelle aufweist. Die geeignete geometrische Form der Einschnitte, deren Tiefe und deren Verteilung kann je nach den Eigenschaften der zu recycelnden Verbundbauteile beispielsweise durch Versuche ermittelt werden.

Sollbruchstellen können beispielsweise mit mechanischen Mitteln eingebracht werden, beispielsweise durch ein Messer, bevorzugt durch ein Kreismesser, oder mit einem Laserstrahl. Auch andere Methoden mit präziser und variabler Schnittführung hinsichtlich Form und Tiefe des Schnitts sind möglich. Beispielsweise kann am Rand eines jeden Wafers die Kunststofffolie von der dem Glas abgewandten Seite vollständig oder teilweise aufgeschnitten werden.

In einer Ausführungsform des Verfahrens erfolgt die Belichtung der absorbierenden Materialschicht von jener Seite, bei welcher die Sollbruchstellen der Lichtquelle abgewandt sind, beispielsweise mit einer oberhalb des Verbundbauteils angeordneten Lichtquelle. Damit kann zur Trennung des Materials der absorbierenden Schicht von deren Trägermaterial die Schwerkraft ausgenutzt werden. Darüber hinaus ist auf diese Weise die Strahlungsquelle vor Beschädigungen infolge hoher Gasdrücke während der thermischen Zersetzung oder vor Verschmutzung durch Ruß aus den Gasen geschützt.

In einer weiteren Ausführungsform werden Verbundbauteile behandelt, welche mindestens eine für sichtbares Licht und/oder UV-Licht transparente Materialschicht aufweisen. Es sind verschiedenartige Verbundbauteile bekannt, deren Materialien zur Weiterverwertung recycelt werden sollen und welche eine Träger- oder Deckschicht aufweisen. Sofern diese transparent für das Licht der Strahlungsquelle des Verfahrens sind, ist eine Belichtung durch diese Schicht hindurch und eine Trennung von dieser Schicht möglich.

Die Unterscheidung der Materialschichten in transparente und weitere, lichtabsorbierende Schichten erfolgt nach deren für den Trennungsprozess verwendeten und vorherrschenden optischen Verhalten. So bildet die transparente Materialschicht das Eintrittsfenster zumindest für das sichtbare Licht der externen Strahlungsquelle in das Verbundbauteil und hat zu diesem Zweck eine Transparenz für den für den zur Anwendung kommenden Trennprozess verwendeten Spektralbereich. Materialschichten mit einer Transparenz für sichtbares Licht von über 40% haben sich für die nutzbaren Prozesse als geeignet erwiesen, wobei sich die Prozentangaben der Transparenz auf das Emissionsspektrum der regelmäßig breitbandig emittierenden Gasentladungslampe beziehen. Die mindestens eine Gasentladungslampe kann optional als Blitzlampe betrieben werden, sodass die in das Verbundbauteil eingetragene Energie zu einer vernachlässigbaren Erhöhung der Temperatur des gesamten Verbundbauteils führt.

In Abhängigkeit von der verwendeten Gasentladungslampe, deren Betriebsparameter, vom verwendeten Trennprozess sowie von den Schichtmaterialien kann die spektrale Transparenz neben dem sichtbaren auch andere Bereiche des Emissionsspektrums einschließen, wie beispielsweise Licht im UV-Bereich und/oder IR-Bereich.

Das Verfahren kann auch auf Verbundbauteile angewendet werden, dessen transparente Materialschichten höhere Transparenzwerte oder auf die betreffenden Spektralbereiche abgestimmte Transparenzprofile aufweisen. Die Transparenz kann durch eine transparente Materialschicht oder mehrere davon, die übereinanderliegen, bestimmt werden.

In weiteren Ausführungsformen des Verfahrens können die Sollbruchstellen der in der Kunststofffolie derart ausgebildet werden, dass sie ergänzend zum Freilegen der zu gewinnenden Materialschicht auch zu deren Extraktion und Trennung von weiteren Bestandteilen des Verbundbauteils verwendbar sind.

Wird der Kunststoff beispielsweise nicht entlang geschlossener Bahnen aufgeschnitten, beispielsweise entlang des kompletten Randes eines Wafers, sondern beispielsweise ein Abschnitt mit einer Länge von einem Zentimeter nicht aufgeschnitten, so führt dies dazu, dass eine abschnittsweise zusammenhängende Folie am Verbundbauteil verbleibt. Damit wird die Separierung der verschiedenen Materialien erleichtert und die weiteren, aus dem Stand der Technik infolge Überbelichtung von Verbundbauteilen vorhandenen Probleme, können vermindert oder gänzlich vermieden werden.

Eine solche an den Sollbruchstellen gebrochene, aber noch zusammenhängende Kunststofffolie kann beispielsweise eine Separation des Halbleiterwertstoffs von den metallischen Materialien zur elektrischen Kontaktierung der Halbleiterbauelemente, insbesondere von den Stromsammelschienen, unterstützen.

Stromsammelschienen sind im Allgemeinen verzinnte Kupferleitungen, welche die Wafer elektrisch miteinander verbinden und durch die Stege geführt sind. Dabei läuft die Verbindung fast immer von der Frontseite des einen Wafers zur Rückseite des benachbarten Wafers, sodass die Halbleiterdioden - eine je Wafer - in Reihe geschaltet sind. Wird nun der zuvor erwähnte, nicht geschnittene Abschnitt genau in jenem Bereich des Waferrandes gewählt, in dem die Stromsammelschienen durch den Steg gehen, dann bleiben die Stromsammelschienen nach der Belichtung im Steg haften bzw. vermischen sich nicht mit dem extrahierten Halbleitermaterial, beispielsweise Silizium. Folglich kann das Halbleitermaterial mit dem erfindungsgemäßen Verfahren sortenrein extrahiert werden.

Werden beispielsweise nur drei Seiten eines Waferrandes, also U-förmig eingeschnitten, sodass die Stromsammelschienen, die auf die Unterseite des Wafers führen, nicht durchtrennt werden, dann bleibt dieser Teil der Stromsammelschienen bei der Extraktion des Siliziums mit dem Kunststoff des Stegs verbunden. Die Stromsammelschienen hingegen, die von der Oberseite des Wafers zum gegenüberliegenden Steg führen, bleiben an der Kunststofffolie haften.

In manchen Fällen, in welchen die absorbierende Materialschicht zwischen zwei Kunststofffolien eingebettet ist und die Belichtung der absorbierenden Materialschicht mit einer Mindestlichtdosis durch eine transparente Materialschicht erfolgt, kann es vorteilhaft sein, das Trennverfahren mit zwei Belichtungsschritten auszuführen. Im ersten Belichtungsschritt werden die zuvor beschriebenen Taschen mittels einer ersten Belichtung bei einer Lichtdosis kleiner als die Mindestlichtdosis erzeugt, mit Gas gefüllt und an den Sollbruchstellen geöffnet.

Die Taschen entstehen in dieser Konstellation an jener Kunststofffolie, welche mit Bezug auf die absorbierende Materialschicht dem Lichteinfall abgewandt ist, hier auch als untere Kunststofffolie bezeichnet. Die Gasentwicklung und damit verbundene Trennung erfolgt jedoch ebenso an der dem Lichteinfall zugewandten oberen Kunststofffolie, jedoch in geringerem Maße. Dabei kann die Ablösung der absorbierenden Materialschicht von der oberen Kunststofffolie nicht oder nur unvollständig sein. Mittels einer zweiten, zeitlich nachfolgenden Belichtung ist es möglich die Taschen der unteren Kunststofffolie vollständig zu öffnen und die zumindest noch abschnittsweise anhaftende absorbierende Materialschicht von der oberen Kunststofffolie zu lösen.

Bei dieser ersten Belichtung wird bevorzugt eine längere Belichtungsdauer als die der nachfolgenden Belichtung verwendet, da zur Öffnung der Taschen die an die untere Kunststofffolie angrenzende Oberfläche des Siliziums erwärmt werden soll, die Lichtabsorption aber an der gegenüberliegenden Oberfläche des Siliziums stattfindet, welche an der oberen Kunststofffolie angrenzt. Folglich wird eine gewisse, materialabhängige Zeit benötigt zur Wärmeübertragung von der Front- zur Rückseite der absorbierenden Materialschicht. Bei der zweiten Belichtung hingegen ist eine wesentlich kürzere Belichtungsdauer ausreichend, beispielsweise um einen Faktor zehn bis hundert kürzer als die erste Belichtungsdauer, da hier die Erwärmung der oberen Oberfläche der absorbierenden Materialschicht gewünscht ist zur vollständigen Ablösung der absorbierenden Materialschicht von der oberen Kunststofffolie und damit von der transparenten Materialschicht.

Idealerweise ist in dieser Verfahrensvariante der durch die Pyrolysegase generierte maximale Druck mittels zwei aufeinanderfolgender Belichtungen reduziert im Vergleich zu einer einmaligen Belichtung. Nachteilige Effekte wie Druckwellen auf die transparente Materialschicht, häufig aus Glas bestehend, bzw. auf die Lichtquelle oder Schwärzungen durch die Pyrolysegase können durch die Doppelbelichtung minimiert werden.

Außerdem kann die maximale Temperatur der transparenten Materialschicht durch eine Doppelbelichtung und die damit verbundenen Folgen reduziert werden. Beispielsweise können bei einer einmaligen Belichtung stark erhitzte Bruchstücke der absorbierenden Materialschicht auf der Unterseite der unteren Kunststofffolie auftreffen und in dieser eingeschmolzen werden. Sofern dieser oder andere negative Effekte aufgrund einer hohen Energiedichte einer einstufigen Belichtung auch bei anderen Ausführungen von Verbundbauteilen auftreten können, kann eine zweistufige Belichtung auch in diesen Fällen angewendet werden.

Für beide Belichtungszeiten sind die oben beschriebenen Varianten in Abhängigkeit von den Parametern der betreffenden Verbundbauteile anwendbar. Wird der zeitliche Abstand zwischen den Belichtungen ausreichend kurz gewählt, sodass die absorbierende Materialschicht am Anfang der zweiten Belichtung eine höhere Temperatur aufweist als am Anfang der ersten Belichtung, kann die Dosis der zweiten Belichtung zur Energieeinsparung reduziert werden. in einer weiteren Variante dieser Ausführungsform des Verfahrens kann auch der erste Belichtungsschritt mehrstufig ausgeführt werden.

Das zuvor beschriebene Verfahren ist auf solche Verbundbauteile anwendbar, deren absorbierende Materialschicht durch eine Mehrzahl von Wafern gebildet ist, wobei mehrere Wafer, alternativ alle Wafer im Belichtungsfeld angeordnet und belichtet werden. Sind diese durch Stege voneinander getrennt, dann sind die sich ausbildenden Taschen durch die Stege begrenzt und eine effektive und reproduzierbare Ausführung des Verfahrens mit hohem Durchsatz ist möglich.

Die Erfindung soll nachfolgend anhand eines Ausführungsbeispiels beispielhaft und nicht beschränkend näher erläutert werden. Der Fachmann würde die zuvor und nachfolgend in den verschiedenen Ausgestaltungen der Erfindung realisierten Merkmale in weiteren Ausführungsformen kombinieren soweit es ihm zweckdienlich und sinnvoll erscheint. In den zugehörigen Zeichnungen zeigt
- Fig. 1: den schematischen Aufbau eines Photovoltaikmoduls als Verbundbauteil gemäß Stand der Technik und
- Fig. 2: eine schematische Darstellung eines Verbundbauteils gemäß Fig. 1 nach Durchführung des erfindungsgemäßen Verfahrens.

Die Figuren zeigen den Erfindungsgegenstand nur schematisch und in einem solchen Umfang, wie es zum Verständnis der Erfindung erforderlich ist. Sie erheben keinen Anspruch auf Vollständigkeit oder Maßstäblichkeit.

Zu Fig. 1 wird auf die obigen Darlegungen zum Stand der Technik über den Aufbau eines Photovoltaikmoduls 00 als Beispiel eines mit dem Verfahren behandelbaren Verbundbauteils verwiesen. Das derzeit bevorzugte Verbundbauteil ist ein Photovoltaikmodul mit Frontseitenglas und Rückseitenfolie. Das Verfahren ist jedoch auch auf andere Verbundbauteile mit prinzipiell vergleichbarem Schichtaufbau anwendbar.

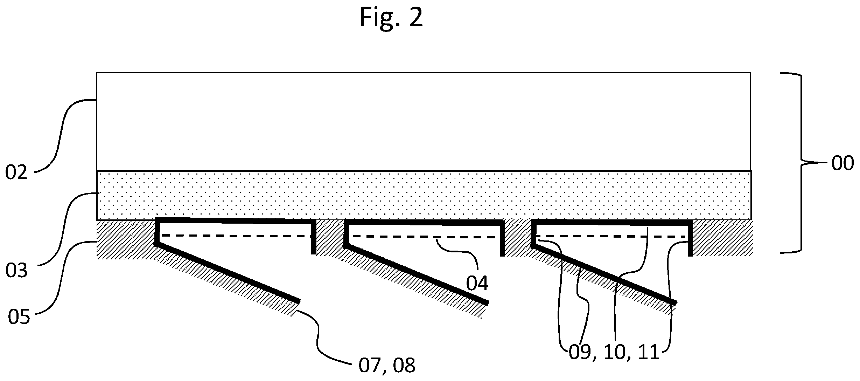

Die Fig. 2 zeigt das Verbundbauteil nach der Durchführung des erfindungsgemäßen Verfahrens, wobei die untere Kunststofffolie 05 im Randbereich 07 der Wafer 04 (gestrichelt dargestellt) abschnittsweise aufgeschnitten wurde und die Wafer 04 entfernt wurden.

Zur Trennung der Wafer 04 von der oberen Kunststofffolie 03 und der unteren Kunststofffolie 05 werden in die untere Kunststofffolie 05 zunächst Sollbruchstellen 08 mittels Laser (nicht dargestellt), alternativ mit einem mechanischen Messer eingebracht. Die Sollbruchstellen 08 verlaufen um den Wafer 04 in dessen Randbereich 07, jedoch nicht vollumfänglich.

Nachfolgend wird das Photovoltaikmodul 00 mittels parallel in einer Ebene angeordneter, zylinderförmiger Blitzlampen (nicht dargestellt) innerhalb eines zur Lampenebene parallelen Belichtungsfeldes, welches alle dargestellten Wafer einschließt, 10 Millisekunden lang belichtet (in Fig. 1 dargestellt durch eine Vielzahl parallel verlaufender Pfeile). Das Licht der Blitzlampen führt zu einer starken Erwärmung der Wafer 04, welche hier als lichtabsorbierende Materialschicht fungieren. In den Grenzlagen 09 der oberen Kunststofffolie 03 und der unteren Kunststofffolie 05 werden thermische Zersetzungsprozesse ausgelöst, so dass sich in beiden Grenzlagen zum Wafer 04 Pyrolysegase bilden.

Letztere führen in der unteren Kunststofffolie 05 sowie in der oberen Kunststofffolie 03 zunächst zum Aufblähen von Folientaschen 10, in denen jeweils ein Wafer 04 eingebettet ist, und zum Bruch der unteren Kunststofffolie 05 entlang der Sollbruchstellen 08.

Die Pyrolysegase der oberen Kunststofffolie 03 sammeln sich in der Grenzlage 09 als Gasschicht 11 (dargestellt als dicke, schwarze Linie) und bewirken auch hier eine Trennung der Wafer 04 von der oberen Kunststofffolie 03. Eine solche Gasschicht 11, wie an der Oberseite des Wafers 04 dargestellt, bildet sich auch an dessen Unterseite. Nach dem Bruch der Sollbruchstellen 08 entweicht das Gas der unteren Gasschicht.

Infolge der Brüche der unteren Kunststofffolie 05 an jedem Wafer 04 öffnen sich die Taschen 10 und die Wafer 04, welche unter der Wirkung des Drucks der Pyrolysegase von beiden Kunststofffolien 03, 05 getrennt sind, können nunmehr aus den offenen Taschen 10 fallen. Aufgrund des Drucks zerbricht der Wafer 04 meist in bis zu mehreren Quadratzentimeter große Stücke, die beim Öffnen der Klappe aus der Tasche 10 herausgeschleudert werden. Das Silizium kann nunmehr leicht von den weiteren Materialien getrennt werden.

Sind die Randbereiche 07 der Wafer 04 vollumfänglich geschnitten, können sich die den Wafer 04 bedeckenden Bereiche der unteren Kunststofffolie 05 vom Rest des Moduls vollständig trennen und den Wafer 04 zur Extraktion freilegen.

Zusammenfassend bietet das erfindungsgemäße Verfahren unter anderem folgende Vorteile:
- Das Verfahren ist zur Extraktion von Wertstoffen aus verschiedenen Verbundbauteilen geeignet. Die bei einer thermischen Zersetzung von Kunststoffen entstehenden Gase unterstützen den Trennungsvorgang, so dass, durch die Sollbruchstellen bedingt, der Wertstoff gezielt aus dem Verbundbauteil heraustreten kann.
- Die bevorzugte Strahlungsquelle ist eine oder mehrere Gasentladungslampen, beispielsweise Blitzlampen aufgrund der damit erzeugbaren steilen Erwärmungsrampen sowie die Möglichkeit Flächen mit einer Größe von mehreren Quadratmetern in weniger als einer Sekunde zu prozessieren.
- Die Sollbruchstellen sind so wählbar, dass nach der Trennung des Materialverbundes einzelne Materialschichten als Fraktion nicht mit dem extrahierten Wertstoff vermischt werden.
- Das Verfahren ist ein- und mehrstufig ausführbar und damit auf verschiedene Verbundbauteile anpassbar.
- Die Extraktion von Wertstoffen erfolgt effektiver hinsichtlich Energieaufwand und Ertrag an Wertstoffen und ist grundsätzlich auch für Durchlaufverfahren verwendbar.
- Mit dem Verfahren werden die entstehenden Pyrolysegase gezielt von der Belichtungsquelle abgewandten Seite des Verbundmaterials abgeleitet, sodass eine Beeinträchtigung oder Beschädigung der Lichtquelle vermieden wird. Dadurch wird es beispielsweise möglich Photovoltaikmodule mit gebrochener Frontglasscheibe zu prozessieren gemäß dem Verfahren der Patentanmeldung WO 2018/137735 A1.

### Bezugszeichenliste

- 00: Verbundbauteil
- 01: Belichtung
- 02: transparente Materialschicht
- 03: obere Kunststofffolie
- 04: absorbierende Materialschicht, Wafer
- 05: untere Kunststofffolie
- 06: Steg
- 07: Randbereich
- 08: Sollbruchstelle
- 09: Grenzlage
- 10: Folientasche
- 11: Gasschicht

## Patentansprüche

1. Verfahren zur Trennung von Wertstoffen eines mehrere Materialschichten umfassenden Verbundbauteils (00) durch Erwärmung von dessen Schichten mittels zumindest einer externen elektromagnetischen Strahlungsquelle, wobei das Verbundbauteil eine Energie der Strahlungsquelle absorbierende Materialschicht (04) und zumindest eine Kunststofffolie umfasst, welche unmittelbar oder mittelbar unter Zwischenlage einer wärmeleitenden Schicht an die absorbierende Materialschicht (04) grenzt, die Schichtenfolge der zweitgenannten Alternative wird hier auch als absorbierende Schichtenfolge bezeichnet, wobei die absorbierende Materialschicht (04) oder Schichtenfolge mithilfe der Strahlungsquelle in einem Belichtungsfeld, welches zumindest einen Anteil der Oberfläche des Verbundbauteils umfasst, in weniger als einer Sekunde erwärmt wird, wobei die zumindest eine Strahlungsquelle derart betrieben wird, dass zumindest im Belichtungsfeld infolge der Erwärmung der absorbierenden Materialschicht (04) in einer der absorbierenden Materialschicht (04) zugewandten Grenzlage (09) der zumindest einen Kunststofffolie (03, 05) eine pyrolytische Spaltung von chemischen Verbindungen des Kunststoffs unter Entstehung von Pyrolysegas erfolgt, **dadurch gekennzeichnet, dass** vor der Erwärmung zumindest eine Sollbruchstelle (08) derart in die zumindest eine Kunststofffolie (03, 05) eingebracht wird, dass an der Sollbruchstelle (08) die Kunststofffolie (03, 05) unter dem Druck des entstehenden Pyrolysegases bricht.

2. Trennverfahren nach Anspruch 1, **dadurch gekennzeichnet, dass** die Belichtung der absorbierenden Materialschicht (04) von jener Seite des Verbundbauteils (00) erfolgt, welche der Sollbruchstelle (08) abgewandt ist.

3. Trennverfahren nach einem der vorstehenden Ansprüche, **dadurch gekennzeichnet, dass** das Verbundbauteil (00) mindestens eine für sichtbares Licht transparente Materialschicht (02), mit einer Transparenz über 40%, umfasst, wobei die Erwärmung der absorbierenden Materialschicht (04) durch die mindestens eine transparente Materialschicht (02) erfolgt.

4. Trennverfahren nach einem der vorstehenden Ansprüche, **dadurch gekennzeichnet, dass** die geometrische Gestaltung der Sollbruchstellen (08) und deren Verteilung auf der Kunststofffolie (03, 05) derart erfolgt, dass die Kunststofffolie (03, 05) innerhalb des Belichtungsfeldes nach dem Brechen der Sollbruchstellen (08) als eine zusammenhängende und Öffnungen aufweisende Schicht verbleibt.

5. Trennverfahren nach Anspruch 4, **dadurch gekennzeichnet, dass** ein Photovoltaik-Modul behandelt wird und infolge der Erwärmung und dem Bruch der Sollbruchstellen (08) die Bereiche über den Stromsammelschienen des Photovoltaik-Moduls als zusammenhängende Bereiche verbleiben.

6. Trennverfahren nach einem der vorstehenden Ansprüche, **dadurch gekennzeichnet, dass** das Verbundbauteil (00) beidseitig der absorbierenden Materialschicht (04) je eine Kunststofffolie (03, 05) aufweist und die absorbierende Materialschicht (04) oder absorbierende Schichtenfolge mit einer solchen Mindestlichtdosis bestrahlt wird, bei welcher jene Kunststofffolie (03, 05), welche Sollbruchstellen (08) aufweist, an diesen bricht und sich die absorbierende Materialschicht (04) oder absorbierende Schichtenfolge zumindest abschnittsweise von der zweiten Kunststofffolie (03, 05) löst.

7. Trennverfahren nach Anspruch 3 in Kombination mit Anspruch 6, **dadurch gekennzeichnet, dass** die absorbierende Materialschicht (04) in einem ersten Schritt mit einer Lichtdosis in weniger als einer Sekunde bestrahlt und erhitzt wird, welche kleiner ist als die Mindestlichtdosis jedoch den Bruch von Sollbruchstellen (08) verursacht, und anschließend eine zweite Erwärmung der absorbierenden Materialschicht (04) in weniger als einer Sekunde erfolgt, mit welcher die absorbierende Materialschicht (04) von der zweiten Kunststofffolie zumindest abschnittsweise abgelöst wird.

8. Trennverfahren nach Anspruch 7, **dadurch gekennzeichnet, dass** der zweite Erwärmungsschritt in einem solchen zeitlichen Abstand zum ersten erfolgt, bei welchem die Temperatur der absorbierenden Materialschicht (04) zu Beginn des Erwärmungsschritts höher ist als zu Beginn des vorangegangenen Erwärmungsschritts.

9. Trennverfahren nach einem der Ansprüche 7 oder 8, **dadurch gekennzeichnet, dass** der erste Erwärmungsschritt länger dauert als der zweite und/oder ein- oder mehrteilig ausgeführt wird.

10. Trennverfahren nach einem der vorstehenden Ansprüche, **dadurch gekennzeichnet, dass** die Sollbruchstellen (08) mittels mechanischer Mittel und/oder mittels Laser erzeugt werden.

11. Trennverfahren nach einem der vorstehenden Ansprüche, **dadurch gekennzeichnet, dass** die absorbierende Materialschicht (04) durch eine Vielzahl von Wafern gebildet ist und die Belichtung in einem Belichtungsfeld erfolgt, welches n Wafer, mit n als natürliche Zahl und n ≥ 1, oder das Verbundbauteil vollständig umfasst.

12. Trennverfahren nach einem der vorstehenden Ansprüche, **dadurch gekennzeichnet, dass** die Strahlungsquelle zumindest eine Gasentladungslampe oder zumindest ein Laser ist.

## Claims

1. A method for separating recycable materials of a composite component (00) comprising multiple material layers by heating its layers by means of at least one external electromagnetic radiation source, wherein the composite component comprising a material layer (04) which absorbs energy of the radiation source and at least one plastics film which adjoins the absorbing material layer (04) directly or indirectly with the interposition of a thermally conductive layer, here the layer sequence of the second-mentioned alternative is also referred to as absorbing layer sequence, the absorbing material layer (04) or layer sequence being heated in less than a second with the aid of the radiation source in an exposure field comprising at least one portion of the surface of the composite component, **wherein** the at least one radiation source is operated in such a way that at least in the exposure field, on account of the heating of the absorbing material layer (04), in a boundary layer (09) of the at least one plastics film (03, 05) which faces the absorbing material layer (04), a pyrolytic decomposition of chemical compounds of the plastics material are cleaved with creation of pyrolysis gas, **characterized in that** prior to the heating, at least one predetermined breaking location (08) is introduced into the at least one plastics film (03, 05) in such a way that at the predetermined breaking location (08) the plastics film (03, 05) breaks under the pressure of the created pyrolysis gas.

2. The separating method as claimed in claim 1,
**characterized in that** the exposure of the absorbing material layer (04) takes place from that side of the composite component (00) which faces away from the predetermined breaking location (08).

3. The separating method as claimed in either of the preceding claims, **characterized in that** the composite component (00) comprises at least one material layer (02) which is transparent to visible light, having a transparency of more than 40%, the heating of the absorbing material layer (04) taking place through the at least one transparent material layer (02).

4. The separating method as claimed in any of the preceding claims, **characterized in that** the geometric configuration of the predetermined breaking locations (08) and the distribution thereof on the plastics film (03, 05) are effected in such a way that the plastics film (03, 05) remains as a continuous layer having openings within the exposure field after the breaking of the predetermined breaking locations (08).

5. The separating method as claimed in claim 4,
**characterized in that** a photovoltaic module is treated and the regions over the busbars of the photovoltaic module remain as continuous regions on account of the heating and the breaking of the predetermined breaking locations (08).

6. The separating method as claimed in any of the preceding claims, **characterized in that** the composite component (00) has a respective plastics film (03, 05) on both sides of the absorbing material layer (04) and the absorbing material layer (04) or absorbing layer sequence is irradiated with such a minimum light dose which results **in that** plastics film (03, 05) which has predetermined breaking locations (08) breaking at the latter and the absorbing material layer (04) or absorbing layer sequence becoming detached from the second plastics film (03, 05) at least in sections.

7. The separating method as claimed in claim 3 in combination with claim 6, **characterized in that** in a first step the absorbing material layer (04) is irradiated and heated in less than a second with a light dose which is less than the minimum light dose but which causes predetermined breaking locations (08) to break, and second heating of the absorbing material layer (04) in less than a second subsequently takes place, by means of which the absorbing material layer (04) is detached from the second plastics film at least in sections.

8. The separating method as claimed in claim 7,
**characterized in that** the second heating step takes place in a manner separated from the first by such a temporal interval which results in the temperature of the absorbing material layer (04) at the beginning of the heating step being higher than at the beginning of the preceding heating step.

9. The separating method as claimed in either of claims 7 and 8, **characterized in that** the first heating step lasts longer than the second and/or is implemented in one or more parts.

10. The separating method as claimed in any of the preceding claims, **characterized in that** the predetermined breaking locations (08) are produced by means of mechanical means and/or by means of lasers.

11. The separating method as claimed in any of the preceding claims, **characterized in that** the absorbing material layer (04) is formed by a multiplicity of wafers and the exposure takes place in an exposure field comprising n wafers, where n is a natural number and n ≥ 1, or the composite component in its entirety.

12. The separating method as claimed in any of the preceding claims, **characterized in that** the radiation source is at least one gas discharge lamp or at least one laser.

## Revendications

1. Procédé pour la séparation de matériaux de valeur d'un composant composite (00) comprenant plusieurs couches de matériau en chauffant ses couches au moyen d'au moins une source de rayonnement électromagnétique externe, dans lequel le composant composite comprend une couche de matériau (04) absorbant l'énergie de la source de rayonnement et au moins un film en matière plastique qui avoisine, directement ou indirectement avec interposition d'une couche thermoconductrice, la couche de matériau absorbante (04), la succession de couches de la seconde alternative étant également désignée ici comme succession de couches absorbantes, dans lequel la couche de matériau absorbante (04) ou la succession de couches est chauffée en moins d'une seconde à l'aide de la source de rayonnement dans un champ d'exposition lumineuse comprenant au moins une fraction de la surface du composant composite, dans lequel l'au moins une source de rayonnement fonctionne de telle sorte que, au moins dans le champ d'exposition lumineuse, à la suite du chauffage de la couche de matériau absorbante (04), dans un emplacement limite (09) de l'au moins un film en matière plastique (03, 05) qui est tourné vers la couche de matériau absorbante (04), une dégradation par pyrolyse de composés chimiques de la matière plastique en formant un gaz de pyrolyse est effectuée, **caractérisé en ce que**, avant le chauffage, au moins un point de rupture cible (08) est introduit dans l'au moins un film en matière plastique (03, 05) de telle sorte que, au niveau du point de rupture cible (08), le film en matière plastique (03, 05) se rompt sous la pression du gaz de pyrolyse formé.

2. Procédé de séparation selon la revendication 1, **caractérisé en ce que** l'exposition lumineuse de la couche de matériau absorbante (04) est effectuée depuis le côté du composant composite (00) qui est tourné à l'opposé du point de rupture cible (08).

3. Procédé de séparation selon l'une des revendications précédentes, **caractérisé en ce que** le composant composite (00) comprend au moins une couche de matériau (02) transparente à la lumière visible, comportant une transparence supérieure à 40 %, dans lequel le chauffage de la couche de matériau absorbante (04) est effectué à travers l'au moins une couche de matériau transparente (02).

4. Procédé de séparation selon l'une des revendications précédentes, **caractérisé en ce que** la conception géométrique des points de rupture cibles (08) et leur répartition sur le film en matière plastique (03, 05) sont effectuées de telle sorte que le film en matière plastique (03, 05) à l'intérieur du champ d'exposition lumineuse reste, après la rupture des points de rupture cibles (08), une couche cohérente et présentant des ouvertures.

5. Procédé de séparation selon la revendication 4, **caractérisé en ce qu'**un module photovoltaïque est traité et, à la suite du chauffage et de la rupture des points de rupture cibles (08), les zones au-dessus des barres omnibus du module photovoltaïque restent des zones cohérentes.

6. Procédé de séparation selon l'une des revendications précédentes,
**caractérisé en ce que** le composant composite (00) présente, de part et d'autre de la couche de matériau absorbante (04), respectivement un film en matière plastique (03, 05) et la couche de matériau absorbante (04) ou succession de couches absorbantes est irradiée avec une dose de lumière minimale, dans lequel le film en matière plastique (03, 05) qui présente des points de rupture cibles (08) se rompt au niveau de ceux-ci et la couche de matériau absorbante (04) ou succession de couches absorbantes se détache, au moins dans certaines sections, du second film en matière plastique (03, 05).

7. Procédé de séparation selon la revendication 3, en combinaison avec la revendication 6, **caractérisé en ce que** la couche de matériau absorbante (04) est, dans une première étape, irradiée et chauffée en moins d'une seconde avec une dose de lumière inférieure à la dose de lumière minimale mais suffisante pour provoquer la rupture des points de rupture cibles (08), puis un second chauffage de la couche de matériau absorbante (04) est effectué en moins d'une seconde, moyennant quoi la couche de matériau absorbante (04) est détachée, au moins dans certaines sections, du second film en matière plastique.

8. Procédé de séparation selon la revendication 7, **caractérisé en ce que** la seconde étape de chauffage est effectuée à un certain intervalle de temps par rapport à la première, dans lequel la température de la couche de matériau absorbante (04) est plus élevée au début de l'étape de chauffage qu'au début de l'étape de chauffage précédente.

9. Procédé de séparation selon l'une des revendications 7 ou 8, **caractérisé en ce que** la première étape de chauffage dure plus longtemps que la seconde et/ou est mise en œuvre en une ou plusieurs parties.

10. Procédé de séparation selon l'une des revendications précédentes, **caractérisé en ce que** les points de rupture cibles (08) sont réalisés au moyen de moyens mécaniques et/ou au moyen d'un laser.

11. Procédé de séparation selon l'une des revendications précédentes, **caractérisé en ce que** la couche de matériau absorbante (04) est formée par une pluralité de plaquettes et l'exposition lumineuse est effectuée dans un champ d'exposition lumineuse qui comprend n plaquettes, où n est un nombre naturel et n ≥ 1, ou qui comprend entièrement le composant composite.

12. Procédé de séparation selon l'une des revendications précédentes, **caractérisé en ce que** la source de rayonnement est au moins une lampe à décharge à gaz ou au moins un laser.
